# EUROPEAN PATENT APPLICATION

(11) **EP 3 352 221 A2**
(43) Date of publication of application: **25.07.2018**
(21) Application number: 17191049.0
(22) Date of filing: 14.09.2017
(51) Int. Cl.: H01L 27/146, G06K 9/00

(54) **ARRAY SUBSTRATE AND FABRICATING METHOD THEREOF, DISPLAY PANEL, DISPLAY APPARATUS, ELECTRONIC DEVICE, COMPUTER PROGRAM AND RECORDING MEDIUM**

(30) Priority: 14.09.2016 CN 201610827550
(71) Applicant: Beijing Xiaomi Mobile Software Co., Ltd., Beijing 100085 (CN)
(72) Inventor: JIANG, Zhongsheng, Beijing 100085 (CN); LIU, Anyu, Beijing, 100085 (CN)
(74) Representative: Steinbauer, Florian

(57) **Abstract**

The present invention relates to an array substrate and a fabricating method thereof, a display panel, a display apparatus, an electronic device, a computer program and a recording medium. The array substrate comprises: a base; a thin film transistor provided in a first region on a side of the base; a photoelectric sensor, provided in a second region on the side of the base, for fingerprint identification; and a passivation layer provided on a side of both the thin film transistor and the photoelectric sensor away from the base. According to technical solutions of the present invention, by disposing a photoelectric sensor on a base of an array substrate, the photoelectric sensor can be integrated in the array substrate. In a display apparatus manufactured by using the array substrate, it is possible to place a finger at a position corresponding to a second region of the array substrate for fingerprint identification. Thus, there is no need to set an extra fingerprint identification sensor in the display apparatus, thereby simplifying the manufacturing process and improving the stability and integration of the overall structure.

## Description

### TECHNICAL FIELD

The present invention generally relates to the technical field of displaying, and more particularly to an array substrate, a display panel, a display apparatus, a fabricating method of an array substrate, an electronic device, a computer program and a recording medium.

### BACKGROUND

With the diversity of encryption/decryption operations of a smart terminal, fingerprints, which are attributes owned by everyone but varying from person to person, have drawn more and more attention. Accordingly, fingerprint identification modules become more and more widely integrated in smart terminals.

Nowadays, a fingerprint identification module is typically provided in a smart terminal (e.g. a handset) in two manners, one of which is to dispose the fingerprint identification module at the back of the smart terminal and the other of which is to dispose the module at the front of the smart terminal. The fingerprint identification module disposed at the back is usually located in the upper and middle regions of a casing of the terminal, while the fingerprint identification module disposed at the front is integrated with a HOME key.

However, no matter which of the above manners is adopted, it is necessary to fabricate a separate fingerprint identification module and then dispose the same in a smart terminal, which is a complex manufacturing process.

### SUMMARY

In order to address the deficiency in the related art, the present invention provides an array substrate, a display panel, a display apparatus, a fabricating method of an array substrate, an electronic device, a computer program and a recording medium.

According to a first aspect of the present invention, an array substrate is provided. The array substrate comprises: a base; a thin film transistor provided in a first region on a side of the base; a photoelectric sensor, provided in a second region on the side of the base, for fingerprint identification; and a passivation layer provided on a side of both the thin film transistor and the photoelectric sensor away from the base.

Optionally, the array substrate further comprises: a flat layer provided on a side of the passivation layer away from the thin film transistor.

Optionally, the photoelectric sensor comprises at least one of a photodiode, a phototriode and a phototransistor.

According to a second aspect of the present invention, a display panel is provided. The display panel comprises the array substrate.

Optionally, the display panel further comprises: a color film substrate disposed opposite to the array substrate, wherein at least one black matrix is arranged in the color film substrate and disposed opposite to the photoelectric sensor; and a liquid crystal layer provided between the array substrate and the color film substrate.

According to a third aspect of the present invention, a display apparatus is provided. The display apparatus comprises the above-described display panel and further comprises: a backlight module provided on a side of the array substrate away from the color film substrate; and a touch module provided on a side of the color film substrate away from the array substrate, or provided between the array substrate and the color film substrate.

Optionally, the display apparatus further comprises: a control chip electrically connected to the thin film transistor, the photoelectric sensor and the touch module. The touch module transmits a control signal to the control chip when sensing a touch signal at a position corresponding to the photoelectric sensor, so as to control the photoelectric sensor and the thin film transistor corresponding to the photoelectric sensor to start operation.

Optionally, the display apparatus further comprises: a data line and a pixel electrode. The thin film transistor is electrically connected to the data line and the pixel electrode, and the data line transmits a data signal to the pixel electrode via the thin film transistor. The control chip adjusts the data signal transmitted through the data line corresponding to the photoelectric sensor when receiving the control signal, so that light emitted from the backlight module becomes monochromatic light or white light after passing through the display panel.

Optionally, the display apparatus further comprises: a status detection unit configured to detect a working status of the display apparatus and transmit the detected working status to the touch module. The touch module determines whether the display apparatus is in a status of being ready for fingerprint identification when sensing a touch signal at a position corresponding to the photoelectric sensor, and transmits the control signal to the control chip if the display apparatus is in the status of being ready for fingerprint identification.

Optionally, the display apparatus further comprises: a first chip electrically connected to the photoelectric sensor and the touch module; and a second chip electrically connected to the thin film transistor and the touch module. The touch module transmits control signals respectively to the first chip and the second chip when sensing a touch signal at a position corresponding to the photoelectric sensor, so that the first chip controls the photoelectric sensor to start operation and the second chip controls the thin film transistor corresponding to the photoelectric sensor to start operation.

According to a fourth aspect of the present invention, a fabricating method of an array substrate is provided. The method comprises: forming, through a patterning process, a thin film transistor in a first region on a side of a base; forming, through a patterning process, a photoelectric sensor in a second region on the side of the base, for fingerprint identification; and forming a passivation layer on a side of both the thin film transistor and the photoelectric sensor away from the base.

Optionally, the fabricating method further comprises: forming a flat layer on a side of the passivation layer away from the thin film transistor.

According to a fifth aspect of the present invention, an electronic device is provided. The electronic device comprises: a processor; and a memory storing instructions executable by the processor. The electronic device further comprises a display panel or a display apparatus according to the invention.

In one particular embodiment, the steps of the fabricating method of an array substrate are determined by computer program instructions.

Consequently, according to a sixth aspect, the invention is also directed to a computer program for executing the steps of the fabricating method of an array substrate as described above when this program is executed by a computer.

This program can use any programming language and take the form of source code, object code or a code intermediate between source code and object code, such as a partially compiled form, or any other desirable form.

The invention is also directed to a computer-readable information medium containing instructions of a computer program as described above.

The information medium can be any entity or device capable of storing the program. For example, the support can include storage means such as a ROM, for example a CD ROM or a microelectronic circuit ROM, or magnetic storage means, for example a diskette (floppy disk) or a hard disk.

Alternatively, the information medium can be an integrated circuit in which the program is incorporated, the circuit being adapted to execute the method in question or to be used in its execution.

Technical solutions provided by embodiments of the present invention may have the following beneficial effects.

As can be known from the foregoing embodiments, the present invention enables a photoelectric sensor to be integrated in an array substrate, by disposing the photoelectric sensor on a base of the array substrate. In a display apparatus manufactured by using the array substrate, it is possible to place a finger at a position corresponding to a second region of the array substrate for fingerprint identification. Thus, there is no need to set an extra fingerprint identification sensor in the display apparatus, thereby simplifying the manufacturing process and improving the stability and integration of the overall structure.

It is to be understood that both the foregoing general description and the following detailed description are exemplary and explanatory only and are not restrictive of the present invention.

### BRIEF DESCRIPTION OF THE DRAWINGS

The accompanying drawings, which are incorporated in and constitute a part of this specification, illustrate embodiments consistent with the invention and, together with the description, serve to explain the principles of the invention.
Fig. 1 is a schematic diagram illustrating a structure of an array substrate according to an exemplary embodiment.
Fig. 2 is a schematic diagram illustrating a principle of fingerprint identification according to an exemplary embodiment.
Fig. 3 is a schematic diagram illustrating a structure of another array substrate according to an exemplary embodiment.
Fig. 4 is a schematic diagram illustrating a structure of a display panel according to an exemplary embodiment.
Fig. 5 is a schematic diagram illustrating a structure of another display panel according to an exemplary embodiment.
Fig. 6 is a schematic flowchart illustrating a fabricating method of an array substrate according to an exemplary embodiment.
Fig. 7 is a schematic flowchart illustrating another fabricating method of an array substrate according to an exemplary embodiment.
Fig. 8 is a block diagram illustrating a display apparatus according to an exemplary embodiment.

### DETAILED DESCRIPTION

Reference will now be made in detail to exemplary embodiments, examples of which are illustrated in the accompanying drawings. The following description refers to the accompanying drawings in which the same numbers in different figures represent the same or similar elements unless otherwise indicated. The implementations set forth in the following description of embodiments do not represent all implementations consistent with the invention. Instead, they are merely examples of apparatuses and methods consistent with aspects related to the invention as recited in the appended claims.

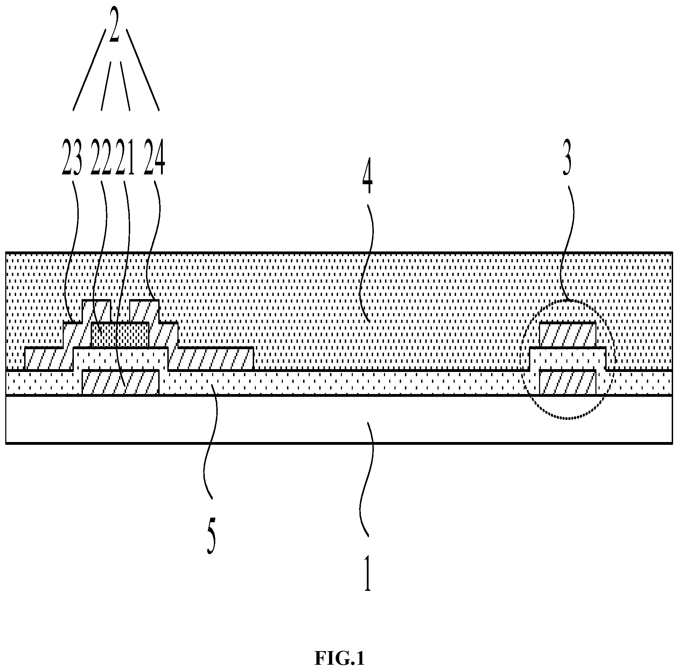

Fig. 1 is a schematic diagram illustrating a structure of an array substrate according to an exemplary embodiment. As shown in Fig. 1, the array substrate comprises: a base 1, a thin film transistor 2 and a photoelectric sensor 3.

In an embodiment, the material of the base may be glass. However, when the array substrate is suitable for a flexible display apparatus, the material of the base may be flexible resin.

The thin film transistor 2 is provided in a first region on a side of the base 1.

In an embodiment, as shown in Fig. 1, the thin film transistor 2 may comprise components, such as a gate 21, an active layer 22, a source 23, a drain 24, etc. A gate insulator layer 5 may be provided between the gate 21 and the active layer 22.

The photoelectric sensor 3 is provided in a second region on the side of the base 1, for fingerprint identification.

In an embodiment, the photoelectric sensor may be formed on the base, through the same process as for the thin film transistor, e.g., through a patterning process.

In an embodiment, the structure of the photoelectric sensor is not limited to the structure shown in Fig. 1, and the position of the photoelectric sensor is not limited to the position shown in Fig. 1 and also not limited to being directly formed on a base as shown in Fig. 1. For example, the photoelectric sensor may be formed on a thin film transistor. In other words, it may be formed when forming a source and a drain or thereafter. In this case, there may be an overlapping region between the first region and the second region.

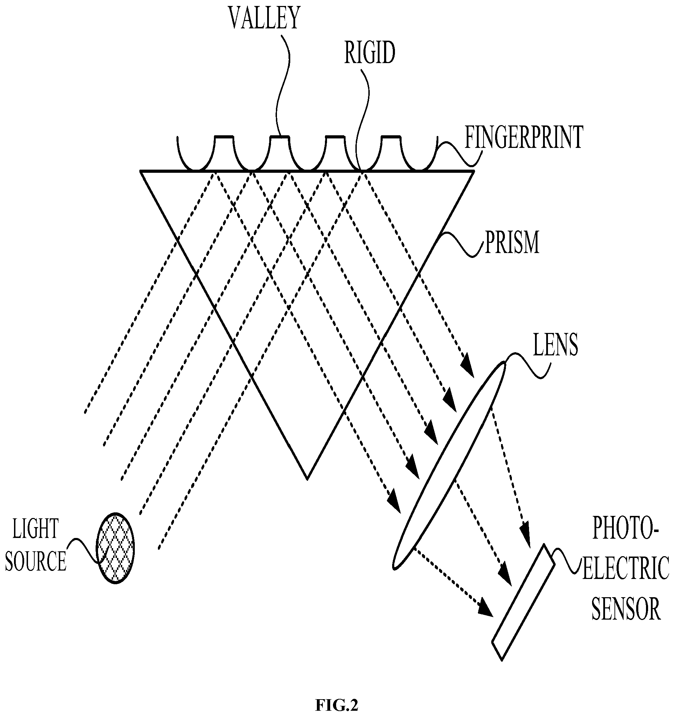

Fig. 2 is a schematic diagram illustrating a principle of fingerprint identification according to an exemplary embodiment. As shown in Fig. 2, a photoelectric sensor may be a component like a photodiode, a phototriode, a phototransistor, etc. When a user's finger presses on the screen surface, light emitted from a light source may be incident on the fingerprint after passing through prisms and the like. Since heights of valleys and ridges of the fingerprint are different, the ridges closely contact the screen and there are gaps of air between the valleys and the screen. Accordingly, lights reflected at the valleys and ridges after incident thereon are also different. Further, lights incident to the photoelectric sensor after passing through lens are different. The photoelectric sensor may generate a response signal according to the difference between the lights, and determine distribution of valleys and ridges of the fingerprint based on the signal, thereby determining the fingerprint of the user.

The passivation layer 4 is provided on a side of both the thin film transistor 2 and the photoelectric sensor 3 away from the base 1.

In an embodiment, the passivation layer may be made of an insulating material, which is for example silicon oxide, silicon nitride, etc.

In the embodiments, by disposing a photoelectric sensor on a base of an array substrate, the photoelectric sensor can be integrated in the array substrate. In a display apparatus manufactured by using the array substrate, it is possible to place a finger at a position corresponding to a second region of the array substrate for fingerprint identification. Thus, there is no need to set an extra fingerprint identification sensor in the display apparatus, thereby simplifying the manufacturing process and improving the stability and integration of the overall structure.

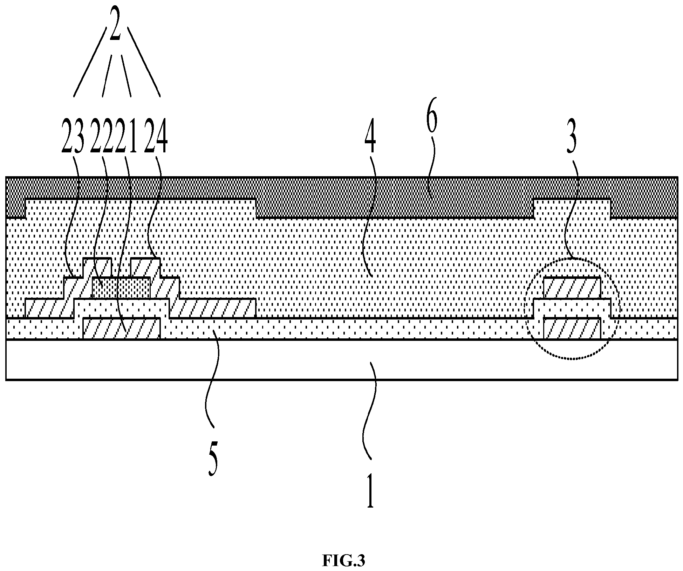

Fig. 3 is a schematic diagram illustrating a structure of another array substrate according to an exemplary embodiment. As shown in Fig. 3, on the basis of the embodiment illustrated in Fig. 1, the array substrate further comprises a flat layer 6 provided on a side of the passivation layer 4 away from the thin film transistor 2.

The case for the passivation layer 4 illustrated in Fig. 1 is an ideal one, in which the upper surface of the passivation layer 4 is relatively flat. In fact, the thin film transistor and the photoelectric sensor which are below the passivation layer 4 protrude relative to the base, so the upper surface of the passivation layer 4 is actually not flat as illustrated in Fig. 3. By further forming a flat layer 6 on the passivation layer 4, the upper surface of the overall structure can be ensured to be relatively flat, thereby facilitating formation of other structures thereon.

Optionally, the photoelectric sensor includes at least one of a photodiode, a phototriode, and a phototransistor.

A user may choose a photodiode and/or a phototriode as a photoelectric sensor for fingerprint sensing according to practical demands.

The present invention further provides a display panel comprising the foregoing array substrate.

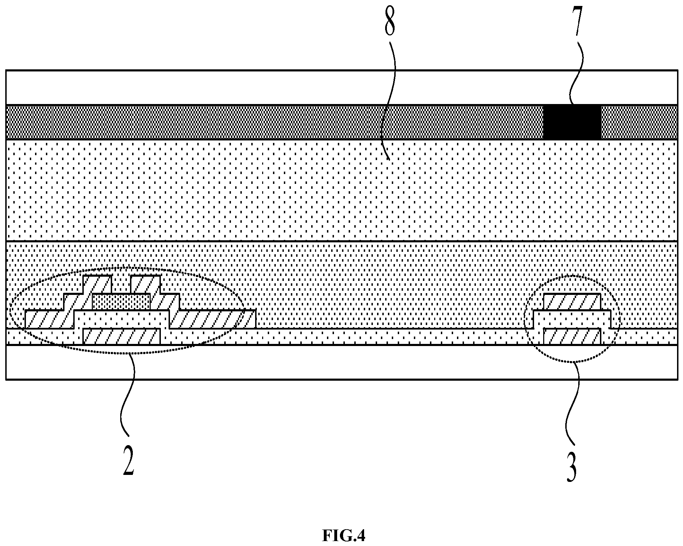

Fig. 4 is a schematic diagram illustrating a structure of a display panel according to an exemplary embodiment. In Fig. 4, structures of the thin film transistor 2 and the photoelectric sensor 3 are simply illustrated. The display panel comprises the foregoing array substrate, and further comprises a color film substrate and a liquid crystal layer 8.

The color film substrate is disposed opposite to the array substrate. A black matrix 7 is arranged in the color film substrate and disposed opposite to the photoelectric sensor 3.

The liquid crystal layer 8 is provided between the array substrate and the color film substrate.

In an embodiment, a color film substrate includes not only a black matrix but also at least one color filtering region provided between elements of the black matrix. Each color filtering region is filled with a color filtering material for the corresponding color. For example, there may be provided a red color filtering region, a green color filtering region and a blue color filtering region. Furthermore, there may be further provided a white color filtering region.

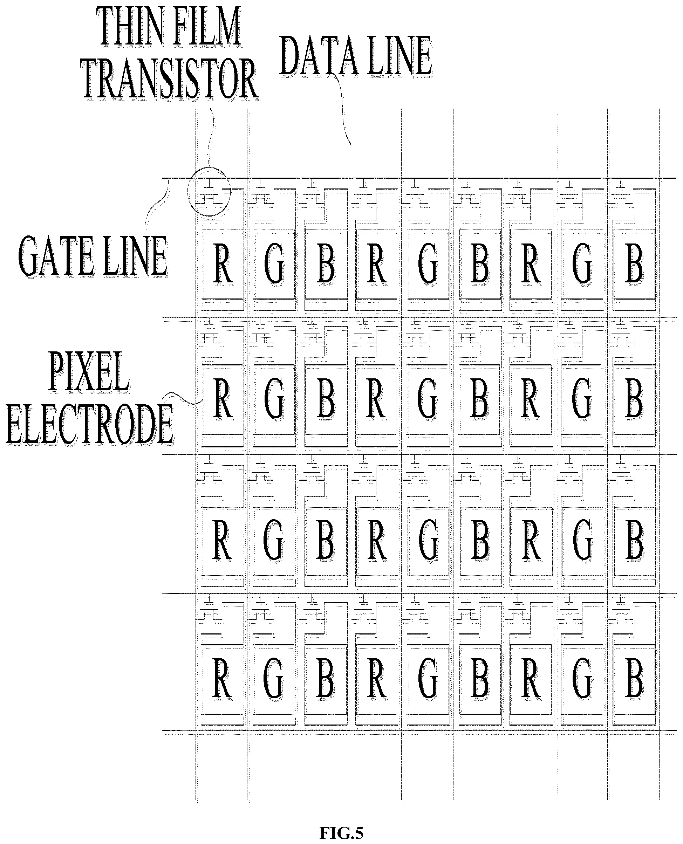

Fig. 5 is a schematic diagram illustrating a structure of another display panel according to an exemplary embodiment. As shown in Fig. 5, the display panel may include multiple data lines and multiple gate lines. The gate lines and the data lines intersect and define multiple sub pixels. In Fig. 5, characters R, G, B denote red, green, blue sub pixels respectively. In the structure illustrated in Fig. 5, a black matrix (not illustrated in Fig. 5) may be provided at positions where the data lines, the gate lines and / or the thin film transistor are located. Correspondingly, the photoelectric sensor (not illustrated in Fig. 5) may also be provided at these positions so as to be blocked by the black matrix from being seen.

In an embodiment, the black matrix may be disposed correspondingly to the thin film transistor, so as to reduce the influence by a scanning signal in a gate of the thin film transistor on the liquid crystal. In this case, the photoelectric sensor may be provided above the thin film transistor, so that positions of the thin film transistor, the photoelectric sensor and the black matrix correspond to each other. In an embodiment, although it is possible to fabricate a photoelectric sensor by using transparent material, the photoelectric sensor will still decrease light transmittance of its corresponding regions, thereby affecting the aperture opening ratio of the display panel. By correspondingly disposing the photoelectric sensor and the black matrix, regions corresponding to the black matrix become non-transparent due to existence of the black matrix. Thus, even if photoelectric sensors are disposed in these regions, the light transmittance will not decrease. Accordingly, the aperture opening ratio of the display panel can be increased as compared with the case in which photoelectric sensors are disposed at other positions.

The present invention further provides a display apparatus, which comprises the foregoing display panel and further comprises a backlight module and a touch module.

The backlight module is provided on a side of the array substrate away from the color film substrate.

In an embodiment, the backlight module may comprise a light guide plate and a light bar provided on a side of the light guide plate. Light emitted from the light bar is incident on the light guide plate, turned into light emitted from an area light source through refraction and reflection at the light guide plate and then incident towards a display panel.

The touch module is provided on a side of the color film substrate away from the array substrate, or provided between the array substrate and the color film substrate.

In an embodiment, the touch module may be a self-inductance capacitor or a mutual-inductance capacitor. When the touch module is provided on a side of the color film substrate away from the array substrate, its structure may be an OGS structure (e.g., the touch module is provided on protective glass on the outer side of the color film substrate). On the other hand, when the touch module is provided between the array substrate and the color film substrate, its structure may be an On Cell structure (e.g., the touch module is provided between a polarizer on a side of the color film substrate and the base) or an In Cell structure (e.g., the touch module is provided on the array substrate). The user may choose a specific structure of the touch module according to practical demands.

Optionally, the foregoing display apparatus further comprises a control chip.

The control chip is electrically connected to the thin film transistor, the photoelectric sensor and the touch module. The touch module transmits a control signal to the control chip when sensing a touch signal at a position corresponding to the photoelectric sensor, so as to control the photoelectric sensor and the thin film transistor corresponding to the photoelectric sensor to start operation.

In an embodiment, the control chip may comprise a first integrated circuit, a second integrated circuit and a signal generator electrically connected to these two integrated circuits respectively.

The signal generator is electrically connected to the touch module, and generates and sends a starting signal to the first integrated circuit and the second integrated circuit when receiving a control signal from the touch module. The first integrated circuit may be electrically connected to the thin film transistor via a gate line, and transmits a scanning signal to the gate of the thin film transistor when receiving the starting signal, making the thin film transistor start operation. On the other hand, when receiving the starting signal, the second integrated circuit may control the photoelectric sensor to start operation through wires connected with the photoelectric sensor. Thus, when the user touches the position corresponding to the photoelectric sensor, identification of the user's fingerprint is triggered.

In an embodiment, the thin film transistor and the photoelectric sensor may be connected with one control chip. This control chip may transmit a scanning signal to the thin film transistor, and determine fingerprint information based on the electrical signal from the photoelectric sensor. Thus, a first wire connected to the thin film transistor and a second wire connected to the photoelectric sensor can be drawn from the single chip. This facilitates parallel arrangement of the first wire and the second wire and eliminates intersection of the first wire and the second wire, thereby decreasing the complexity of wiring.

The control chip may be a COG (Chip On Glass). In other words, the control chip is directly formed on the base of the array substrate, so as to decrease the volume of the display apparatus where the array substrate is located.

Optionally, the display apparatus further comprises a data line and a pixel electrode. The thin film transistor is electrically connected to the data line and the pixel electrode, and the data line transmits a data signal to the pixel electrode via the thin film transistor. The control chip adjusts the data signal transmitted through the data line corresponding to the photoelectric sensor when receiving the control signal, so that light emitted from the backlight module becomes monochromatic light or white light after passing through the display panel.

In an embodiment, the data line may be electrically connected to a source of the thin film transistor, while the pixel electrode may be electrically connected to a drain of the thin film transistor through a throughhole in the passivation layer. Thus, when the thin film transistor is enabled (namely, turned on), the data signal on the data line may be transmitted to the pixel electrode through a source, an active layer and a drain of the thin film transistor.

In an embodiment, light sensed by a photoelectric sensor is incident from a light guide plate towards a display panel, then towards a finger through the display panel, and is next reflected towards the photoelectric sensor by the finger. As currents induced from lights of different colors by the photoelectric sensor are different, when the light from the display panel to the finger is not white light but light of mixed colors, the photoelectric sensor may receive, at different regions thereof, reflected lights of different colors, due to spectroscopic effect exerted on the light of mixed colors by material of the display panel. Accordingly, the photoelectric sensor produces an unstable current, which affects the detection result.

When the light from the display panel to the finger is white light, light finally reaching the photoelectric sensor is still mixed into white light, even after undergoing the spectroscopic effect of the material in the display panel. When the light from the display panel to the finger is monochromatic light, no spectroscopic effect will occur during propagation of the light and the light finally reaching the photoelectric sensor is still monochromatic light.

As such, by adjusting the data signal when receiving the control signal, the control chip can adjust the voltage of the pixel electrode to change the deflection of the liquid crystal at the position of the photoelectric sensor, so that red, green and blue sub pixels at the position are all enabled. Accordingly, all the white light incident from the backlight module to the display panel can be emitted out and remain white light after passing through the display panel. Further, the light reflected by the user's finger and the light incident on the photoelectric sensor are still white light. Alternatively, it is possible to enable only a single color sub pixel (e.g., enable the red sub pixel), so that the white light can pass through only the area of the red sub pixel and is filtered by red color filtering material to leave only read light to be emitted out. Accordingly, the light emitted from the display panel is monochromatic red light. Further, the light reflected by the user's finger and the light incident on the photoelectric sensor are also red light.

Optionally, the display apparatus further comprises: a status detection unit configured to detect a working status of the display apparatus and transmit the detected working status to the touch module. The touch module determines whether the display apparatus is in a status of being ready for fingerprint identification when sensing a touch signal at a position corresponding to the photoelectric sensor, and transmits the control signal to the control chip if the display apparatus is in the status of being ready for fingerprint identification.

As the photoelectric sensor is provided in the array substrate (that is, in an effective display region of the display panel), the user may click on an area corresponding to the photoelectric sensor even when performing an operation not requiring fingerprint identification. In this case, waste of power will be incurred if the photoelectric sensor is started.

In an embodiment, by further detecting a working status of the display apparatus, it may be determined whether the display apparatus is in a status of being ready for fingerprint identification when a user clicks on a position corresponding to the photoelectric sensor. The status of being ready for fingerprint identification may include a screen locked status, a fingerprint payment verification status, etc. When the display apparatus is in such a status, it can be determined that the operation of clicking the position corresponding to the photoelectric sensor by the user requires fingerprint identification and the photoelectric sensor is started to operate then. As such, waste of power and loss caused by frequent switching on and off of the photoelectric sensor can be can effectively avoided.

Optionally, the display apparatus further comprises: a first chip electrically connected to the photoelectric sensor and the touch module; and a second chip electrically connected to the thin film transistor and the touch module. The touch module transmits control signals respectively to the first chip and the second chip when sensing a touch signal at a position corresponding to the photoelectric sensor, so that the first chip controls the photoelectric sensor to start operation and the second chip controls the thin film transistor corresponding to the photoelectric sensor to start operation.

In the embodiment, one chip transmits a scanning signal to the thin film transistor and a different chip processes an electrical signal from the photoelectric sensor. Compared with the embodiment in which one control chip not only transmits a scanning signal to the thin film transistor but also processes an electrical signal from the photoelectric sensor, the structure is more simple and easier to be fabricated since the first chip and the second chip implement partial functions respectively.

Depending on process requirements, it is optional whether the thin film transistor and the photoelectric sensor are connected to respective chips or to one common chip.

Correspondingly to embodiments of the foregoing array substrates, the present invention further provides embodiments of a fabricating method of an array substrate.

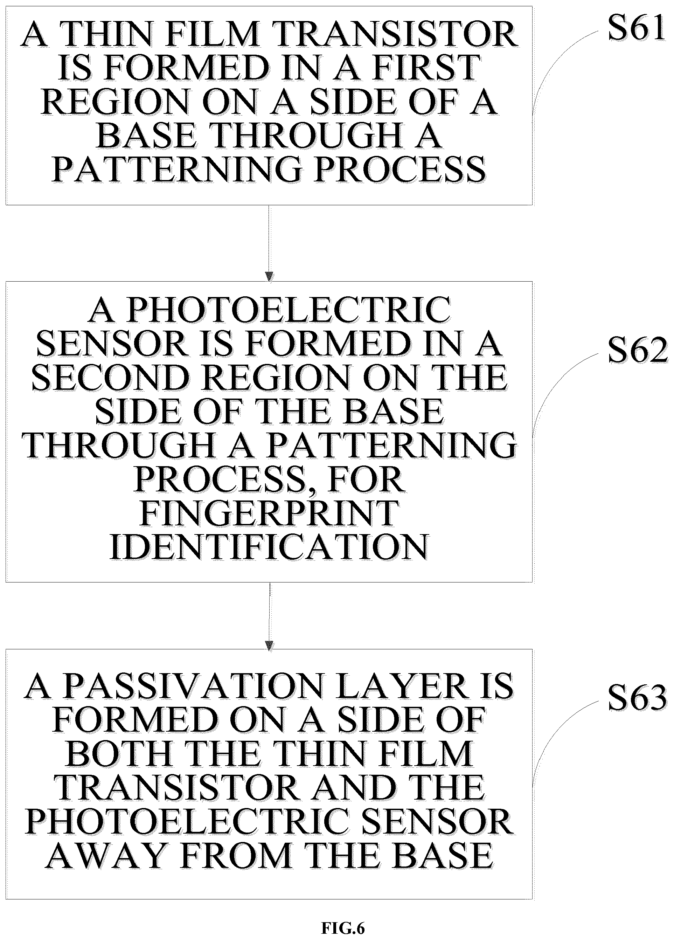

Fig. 6 is a schematic flowchart illustrating a fabricating method of an array substrate according to an exemplary embodiment. As shown in Fig. 6, the fabricating method comprises the following steps.

At step S61, a thin film transistor is formed in a first region on a side of a base through a patterning process.

At step S62, a photoelectric sensor is formed in a second region on the side of the base through a patterning process, for fingerprint identification.

At step S63, a passivation layer is formed on a side of both the thin film transistor and the photoelectric sensor away from the base.

In an embodiment, if the photoelectric sensor is also formed on the base, the step S61 and the step S62 may be performed simultaneously. That is, the photoelectric sensor is formed while forming the thin film transistor. If the photoelectric sensor is formed above the thin film transistor, then the step S61 may be performed before the step S62. In addition, an insulation layer may be further disposed above the thin film transistor, to insulate the source and the drain of the thin film transistor from the photoelectric sensor.

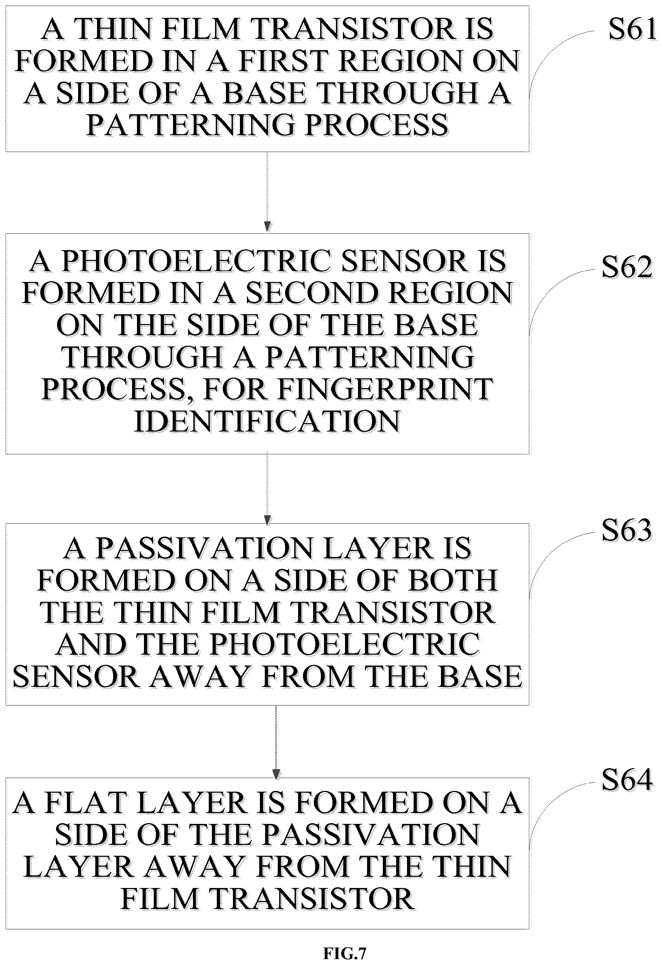

Fig. 7 is a schematic flowchart illustrating another fabricating method of an array substrate according to an exemplary embodiment. As shown in Fig. 7, on the basis of the embodiment illustrated in Fig. 6, the fabricating method further comprises a step S64.

At step S64, a flat layer is formed on a side of the passivation layer away from the thin film transistor.

Regarding the fabricating method in the above embodiments, the specific manners for implement the individual steps have been described in detail in the embodiments of the related array substrate and will not be elaborated herein.

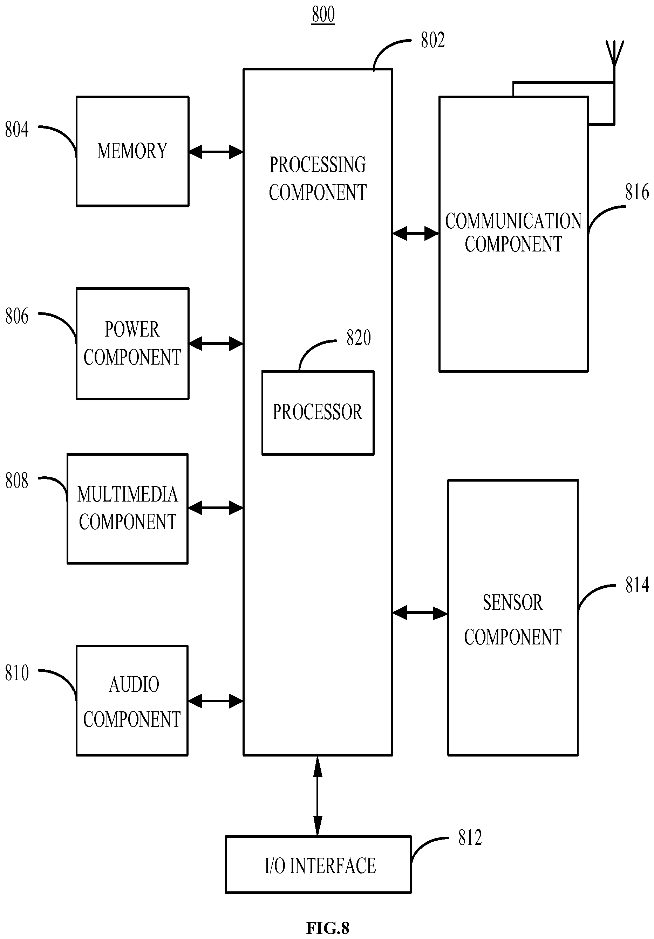

Fig. 8 is a block diagram illustrating a display apparatus 800 according to an exemplary embodiment. For example, the apparatus 800 may be a mobile phone, a computer, a digital broadcast terminal, a messaging device, a gaming console, a tablet, a medical device, exercise equipment, a personal digital assistant or the like.

Referring to Fig. 8, the apparatus 800 may include one or more of the following components: a processing component 802, a memory 804, a power component 806, a multimedia component 808, an audio component 810, an input/output (I/O) interface 812, a sensor component 814 and a communication component 818. The apparatus 800 may further include an array substrate. The array substrate comprises: a base; a thin film transistor provided on one side of the base; a photoelectric sensor provided on a side of the thin film transistor away from the base and used for fingerprint identification; and a passivation layer provided in a region of the thin film transistor, where the photoelectric sensor is not disposed, and provided on a side of the photoelectric sensor away from the thin film transistor.

The processing component 802 generally controls the overall operations of the apparatus 800, for example, display, phone call, data communication, camera operation and recording operation. The processing component 802 may include one or more processors 820 to execute instructions. In addition, the processing component 802 may include one or more modules to facilitate the interaction between the processing component 802 and other components. For example, the processing component 802 may include a multimedia module to facilitate the interaction between the multimedia component 808 and the processing component 802.

The memory 804 is configured to store various types of data to support the operation performed on the apparatus 800. Examples of such data include any application operated on the apparatus 800, contact data, phonebook data, messages, pictures, video, etc. The memory 804 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 806 provides power to various components of the apparatus 800. The power component 806 may include a power supply management system, one or more power sources, and any other components associated with the generation, management, and distribution of power in the apparatus 800.

The multimedia component 808 includes a screen providing an output interface between the apparatus 800 and the user. In some embodiments, the screen may include a Liquid Crystal Display (LCD) and a Touch Panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swipe action, but also sense a period of time and a pressure associated with the touch or swipe action. In some embodiments, the multimedia component 808 includes a front camera and/or a rear camera. The front camera and the rear camera may receive external multimedia data while the apparatus 800 is in an operation mode, such as a photographing mode or a video mode. Each of the front camera and the rear camera may be a fixed optical lens system or have focus and optical zoom capability.

The audio component 810 is configured to output and/or input audio signals. For example, the audio component 810 includes a microphone (MIC) configured to receive an external audio signal when the apparatus 800 is in an operation mode, such as a call mode, a recording mode, and a voice recognition mode. The received audio signal may be further stored in the memory 804 or transmitted via the communication component 818. In some embodiments, the audio component 810 further includes a speaker to output audio signals.

The I/O interface 812 provides an interface between the processing component 802 and peripheral interface modules, such as a keyboard, a click wheel, buttons, and the like. The buttons may include, but are not limited to, a home button, a volume button, a starting button, and a locking button.

The sensor component 814 includes one or more sensors to provide status assessments of various aspects of the apparatus 800. For instance, the sensor component 814 may detect an open/closed status of the apparatus 800, relative positioning of components, e.g., the display and the keypad, of the apparatus 800, a change in position of the apparatus 800 or a component of the apparatus 800, a presence or absence of user contact with the apparatus 800, an orientation or an acceleration/deceleration of the apparatus 800, and a change in temperature of the apparatus 800. The sensor component 814 may include a proximity sensor configured to detect the presence of nearby objects without any physical contact. The sensor component 814 may also include a light sensor, such as a CMOS or CCD image sensor, for use in imaging applications. In some embodiments, the sensor component 814 may also include an accelerometer sensor, a gyroscope sensor, a magnetic sensor, a pressure sensor or a temperature sensor.

The communication component 818 is configured to facilitate wired or wireless communication between the apparatus 800 and other devices. The apparatus 800 can access a wireless network based on a communication standard, such as WiFi, 2G, or 3G, or a combination thereof. In one exemplary embodiment, the communication component 818 receives a broadcast signal or broadcast related information from an external broadcast management system via a broadcast channel. In one exemplary embodiment, the communication component 818 further includes a near field communication (NFC) module to facilitate short-range communications. For example, the NFC module may be implemented based on a radio frequency identification (RFID) technology, an infrared data association (IrDA) technology, an ultra-wideband (UWB) technology, a Bluetooth (BT) technology, and other technologies.

In exemplary embodiments, the apparatus 800 may be implemented with one or more application specific integrated circuits (ASIC), digital signal processors (DSP), digital signal processing devices (DSPD), programmable logic devices (PLD), field programmable gate arrays (FPGA), controllers, micro-controllers, microprocessors, or other electronic components.

In exemplary embodiments, there is also provided a non-transitory computer-readable storage medium including instructions, such as included in the memory 804, executable by the processor 820 of the apparatus 800. For example, the non-transitory computer-readable storage medium may be a ROM, a RAM, a CD-ROM, a magnetic tape, a floppy disc, an optical data storage device, and the like.

Other embodiments of the invention will be apparent to those skilled in the art from consideration of the specification and practice of the invention disclosed here. This application is intended to cover any variations, uses, or adaptations of the invention following the general principles thereof and including such departures from the present disclosure as come within known or customary practice in the art. It is intended that the specification and examples be considered as exemplary only, with a true scope of the invention being indicated by the appended claims.

It will be appreciated that the present invention is not limited to the exact construction that has been described above and illustrated in the accompanying drawings, and that various modifications and changes can be made without departing from the scope thereof. It is intended that the scope of the invention only be limited by the appended claims.

## Claims

1. An array substrate, comprising:
a base (11);
a thin film transistor (12) provided in a first region on a side of the base;
a photoelectric sensor (13), provided in a second region on the side of the base, for fingerprint identification; and
a passivation layer (14) provided on a side of both the thin film transistor and the photoelectric sensor away from the base.

2. The array substrate according to claim 1, further comprising:
a flat layer (6) provided on a side of the passivation layer away from the thin film transistor.

3. The array substrate according to claim 1 or 2, wherein the photoelectric sensor comprises at least one of a photodiode, a phototriode and a phototransistor.

4. A display panel, comprising an array substrate according to any one of claims 1 to 3.

5. The display panel according to claim 4, further comprising:
a color film substrate disposed opposite to the array substrate, wherein at least one black matrix is arranged in the color film substrate and disposed opposite to the photoelectric sensor; and
a liquid crystal layer (8) provided between the array substrate and the color film substrate.

6. A display apparatus, comprising a display panel according to claim 5 and further comprising:
a backlight module provided on a side of the array substrate away from the color film substrate; and
a touch module provided on a side of the color film substrate away from the array substrate, or provided between the array substrate and the color film substrate.

7. The display apparatus according to claim 6, further comprising:
a control chip electrically connected to the thin film transistor, the photoelectric sensor and the touch module,
wherein the touch module transmits a control signal to the control chip when sensing a touch signal at a position corresponding to the photoelectric sensor, so as to control the photoelectric sensor and the thin film transistor corresponding to the photoelectric sensor to start operation.

8. The display apparatus according to claim 7, further comprising:
a data line and a pixel electrode, wherein the thin film transistor is electrically connected to the data line and the pixel electrode, and the data line transmits a data signal to the pixel electrode via the thin film transistor,
wherein the control chip adjusts the data signal transmitted through the data line corresponding to the photoelectric sensor when receiving the control signal, so that light emitted from the backlight module becomes monochromatic light or white light after passing through the display panel.

9. The display apparatus according to claim 7 or 8, further comprising:
a status detection unit configured to detect a working status of the display apparatus and transmit the detected working status to the touch module,
wherein the touch module determines whether the display apparatus is in a status of being ready for fingerprint identification when sensing a touch signal at the position corresponding to the photoelectric sensor, and transmits the control signal to the control chip if the display apparatus is in the status of being ready for fingerprint identification.

10. The display apparatus according to any one of claims 6 to 9, further comprising:
a first chip electrically connected to the photoelectric sensor and the touch module; and
a second chip electrically connected to the thin film transistor and the touch module,
wherein the touch module transmits control signals respectively to the first chip and the second chip when sensing a touch signal at a position corresponding to the photoelectric sensor, so that the first chip controls the photoelectric sensor to start operation and the second chip controls the thin film transistor corresponding to the photoelectric sensor to start operation.

11. A fabricating method of an array substrate, comprising:
forming (S61), through a patterning process, a thin film transistor in a first region on a side of a base;
forming (S62), through a patterning process, a photoelectric sensor in a second region on the side of the base, for fingerprint identification; and
forming (S63) a passivation layer on a side of both the thin film transistor and the photoelectric sensor away from the base.

12. The fabricating method according to claim 11, further comprising:
forming (S64) a flat layer on a side of the passivation layer away from the thin film transistor.

13. An electronic device, comprising:
a processor (820); and
a memory (804) storing instructions executable by the processor (820),
wherein the electronic device further comprises a display panel according to any one fo claims 1 to 3 or a display apparatus according to any one of claims 6 to 10.

14. A computer program including instructions for executing the steps of a fabricating method of an array substrate according to claim 11 or 12 when said program is executed by a computer.

15. A recording medium readable by a computer and having recorded thereon a computer program including instructions for executing the steps of a fabricating method of an array substrate according to claim 11 or 12.
